**Europäisches Patentamt**

**European Patent Office**

**Office européen des brevets**

(19)

(11) **EP 1 158 659 A1**

(12) # EUROPEAN PATENT APPLICATION

(43) Date of publication:
**28.11.2001 Bulletin 2001/48**

(51) Int Cl.$^7$: **H03C 7/02**

(21) Application number: **00850083.7**

(22) Date of filing: **15.05.2000**

| | |
|---|---|
| (84) Designated Contracting States:<br>**AT BE CH CY DE DK ES FI FR GB GR IE IT LI LU MC NL PT SE**<br>Designated Extension States:<br>**AL LT LV MK RO SI**<br><br>(71) Applicant: **Telefonaktiebolaget L M Ericsson (Publ)**<br>**126 25 Stockholm (SE)** | (72) Inventor: **Zhou, Shu-Ang**<br>**125 51 Älvsjö (SE)**<br><br>(74) Representative: **Sandström, Staffan Sven**<br>**Bergenstrahle & Lindvall AB,**<br>**P.O. Box 17704**<br>**118 93 Stockholm (SE)** |

(54) **Amplitude Modulator using a switched stripline filter**

(57) The invention is mainly related to the use of power amplifiers and modulators in e.g. radio communications systems, and more particularly to the use of switching-mode power amplifiers at high carrier frequencies. A new radio transmitter architecture is provided that is different from that of the conventional radio transmitters that uses an AC carrier signal of constant amplitude and phase. To realise this new radio transmitter, a novel device is proposed based on the following features: the use of switchable bandpass filters to implement digital modulation directly on the AC, RF frequency, carrier wave. This direct modulation may eliminate some undesired non-linear effects, such as intermodulation products which may appear in a convention-

al RF power amplifier. A signal source is used to control an RF switch realised as e.g. a semiconductor or a Josephson junction, among others, depending on the modulation frequency. A low-pass, or band-pass filter is provided. This filter can be switched, thereby amplitude modulating the AC voltage source as it passes through the filter. A preferred embodiment consists of a planar microstrip element having a patterned electrically conducting layer. The patterned layer forms a transmission or propagation path for the signal, the path having a central path with lateral strips separated by windows from the central path. These lateral paths have regions which allow them to be controlled by the control signal, thereby performing the switching function.

Figure 7 Scheme of a switchable low-pass filter.

**Description**

FIELD OF THE INVENTION

The invention is mainly related to the use of power amplifiers and modulators in e.g. radio communications systems, and more particularly to the use of switching-mode power amplifiers at high carrier frequencies.

RELATED ART

High efficiency radio frequency ("RF") power amplifiers and modulators are of importance to radio communications systems. During the past, numbers of high efficient power amplifiers have been proposed in the literature. In particular, the switching-mode power amplifiers, e.g. class D, class E, class S, etc., have received increasing attention for their possible applications in both radio receivers and radio base stations due to their very high efficiency. However, these types of switching-mode power amplifiers are highly non-linear. Special circuit architectures, such as the LINC technique, are usually required for their use in highly linear RF power amplifier applications.

These recent ideas of applying digitally modulated signals directly to switching-mode power amplifiers are promising. However, the operating frequency of these switching-mode power amplifiers is thus far limited and not ready to be used in current radio transmitters with GHz carrier wave frequencies. This is especially true since the high efficiency of these power amplifiers is difficult to maintain due to the upper frequency limit of available RF power transistors and their intrinsic Ohmic losses with the current semiconductor technology.

SUMMARY OF THE INVENTION

The invention is mainly related to the use of power amplifiers and modulators in e.g. radio communications systems, and more particularly to the use of switching-mode power amplifiers at high carrier frequencies.

As can be seen above, there still exists disadvantages with current switching-mode amplifiers. They generally suffer from non-linearities and their efficiencies suffer at higher frequencies.

Accordingly, it is an object of the present invention to provide a system and device to allow RF modulation and power amplification where digitally modulated signals are applied directly to switching-mode power amplifiers.

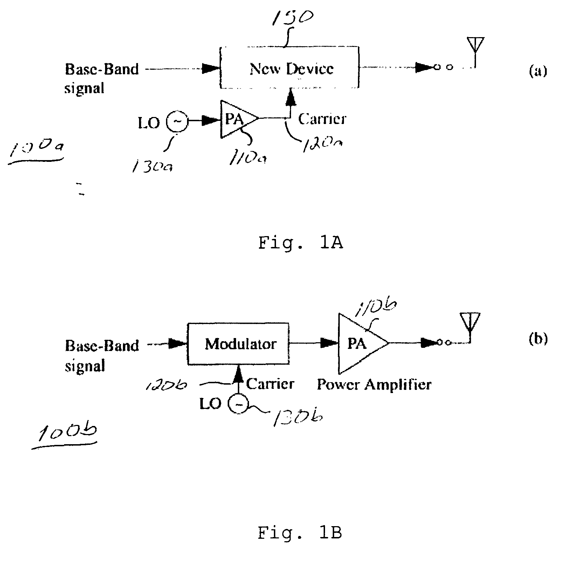

The present invention provides a new radio transmitter architecture as shown in Figure 1A that is different from that of the conventional radio transmitters. In this new radio transmitter architecture the power amplifier is mainly used to amplify a single-frequency carrier wave of constant amplitude, thus allowing the use of highly efficient power amplifiers. Furthermore, different carrier waves of constant frequencies and power control of these carrier waves can be achieved with relative ease by using a variable oscillator and the power control of the power amplifier for the carrier waves of constant amplitude.

To realise this new radio transmitter, a novel device is proposed to implement the modulation of carrier waves with possible high RF power. This novel device is mainly based on the following features: the use of switchable (or tuneable) bandpass filters to implement digital modulation, on RF carrier waves, the modulation being carried out on the carrier wave of high RF power directly by the device. This direct modulation may eliminate some undesired non-linear effects, such as intermodulation products which may appear in a conventional RF power amplifier.

The device uses an AC voltage source as opposed to the DC source voltage used in conventional switching-mode power amplifiers. A signal source is used to control an RF switch realised as e.g. a semiconductor or a Josephson junction, among others, depending on the modulation frequency. A low-pass, or- bandpass filter is provided which can be switched, thereby amplitude modulating the AC voltage source as it passes through the filter. This amplitude-modulated signal has the form of pulses. Since the voltage of the input control signal will be less than that of the carrier, the result is that this device performs both the modulation and the power amplification functions.

The preferred embodiment of this new device is realised in a switchable microwave device, of the type described by the applicant in the Swedish patent application SE 9903315-1. This preferred embodiment consists of a planar microstrip element having a patterned electrically conducting layer. The patterned layer forms a transmission or propagation path for the signal, the path having a central path with two lateral strips separated by windows from the central path. These lateral paths have regions which allow them to be controlled by the control signal, thereby performing the switching function described above.

Although the invention has been summarised above, the present invention is defined according to appended claim 1. Various embodiments are further defined in the dependent claims.

BRIEF DESCRIPTION OF THE DRAWINGS

The present invention will now be described in more detail with reference to preferred embodiments of the present invention, given only by way of example, and illustrated in the accompanying drawings, in which:

> FIG. 1A is a block diagram of a new radio transmitter implementing the device according to the present invention.

FIG. 1B is a block diagram of a conventional radio transmitter.

FIG. 2 is a schematic diagram of the device according to the present invention.

FIG. 3 illustrates the numerical results of a PSPICE simulation of the device in Figure 2.

FIG. 4 illustrates the use of the device of the present invention for quadrature modulation.

FIG. 5 shows a closed view of the voltage- and current-wave form across the load resistor $R_L$.

FIG. 6 shows a closed view of the voltage- and current-wave form across the capacitor $C_s$.

FIG. 7 shows a perspective view of the preferred embodiment of the device according to the present invention.

DETAILED DESCRIPTION

Different from conventional radio transmitter architectures, the device 150 according to the present invention integrates the modulation with the RF power amplification and is proposed for application in a new radio transmitter architecture 100a as shown in Figure 1A in order to eliminate undesirable non-linear effects in radio transmitters with high power efficiency.

The block diagram of the new radio transmitter architecture 100a shown in Figure 1A is different from that of the conventional radio transmitter 100b shown in Figure 1B. In this new radio transmitter architecture 100a, the power amplifier 110a is mainly used to amplify a single-frequency carrier wave 120a of constant amplitude, generated by a local oscillator 130a (multi-stage power amplification may be required, depending on available gain of power amplification for each stage). Thus, highly efficient (non-linear) power amplifiers can be used here. Furthermore, different carrier waves of constant frequencies and power control of these carrier waves can be achieved with relative ease by using a variable oscillator and the power control of the power amplifier 110a for the carrier waves of constant amplitude.

In comparing Figures 1A and 1B it can be seen that the new device 150 incorporates both power amplification features and modulation features. To realise the new radio transmitter 100a as shown in Figure 1A, the novel device 150 is required to implement the modulation of carrier waves with possible high RF power. According to the present invention, a novel device is therefore proposed, which is based mainly on the following ideas:

(1) The use of switchable (or tuneable) bandpass filters to implement digital modulation, such as ASK, QPSK (or others) on RF carrier waves.

(2) A carrier wave of high RF power can be modulated directly by the device.

(3) High-quality (high-Q) switchable bandpass (or low-pass) filters in the device may be realised by using high-temperature superconductors, which may produce high-efficient RF power devices with extremely low Ohmic losses.

(4) The device may achieve a very high-gain in power amplification if the power of the control signals (which could be the digital base-band signal) to control the switchable (or tuneable) bandpass filter is much lower than the RF power of the carrier wave passing through the filter in the device.

(5) The modulation implemented directly on carrier waves of high power in the device may eliminate some undesired non-linear effects, such as intermodulation products which may appear in a conventional RF power amplifier 110b as illustrated in Figure 1B.

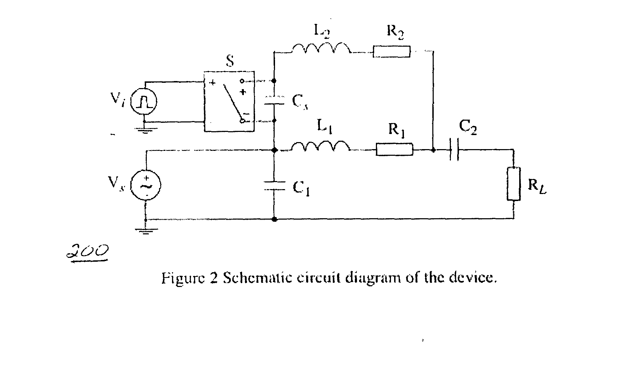

Illustratively, shown in Figure 2 is an example of the schematic circuit diagram 200 for such a device. In the figure, $V_s$ denotes the AC voltage source of constant amplitude and phase, which is different from conventional switching-mode power amplifiers where a DC source voltage is used. Clearly, the carrier wave 120a in Figure 1A plays the role of the AC voltage source in this circuit diagram.

$V_i$ is the signal source (voltage or others) used to control the RF switch S, which is assumed to have a small on-state resistance $R_{on}$ and a large off-state resistance $R_{off}$, depending on how the switch S is practically realised. In practice, the switch could be realised by a semiconductor transistor, a photoconductor, a Josephson junction (or weak link) for superconductive switch, or even a microelectro-mechanical switch, depending on modulation frequency specified among others.

The capacitance $C_s$ across the switch is used to effectively reduce the transient voltage level during switching transient. Generally, $C_s$ has a very small value, which could well be the intrinsic capacitance of the switching device S, including parasitics, depending also on the operating switching frequency.

It can be seen that the inductor $L_1$ and the capacitor $C_1$, in the circuit acts as a low-pass filter. By switching the inductance value of the low-pass filter through the second inductor $L_2$, the cut-off frequency f, of the low-pass filter can therefore be switched. Thus, the AC voltage wave of constant amplitude and phase from the AC voltage source $V_s$ can be modulated when it passes through the switchable filter.

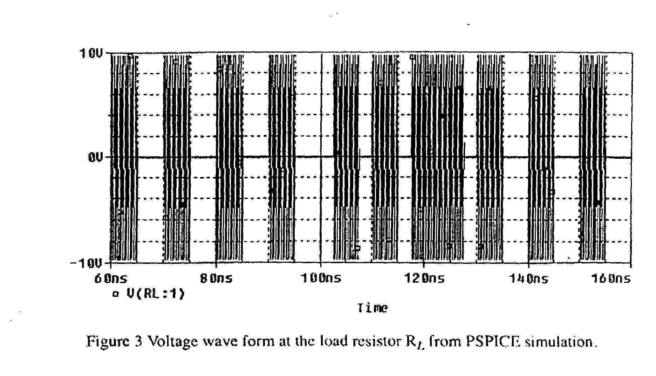

The resulting output voltage wave form at the load resistor $R_L$ is therefore amplitude-modulated, with its envelope having the form of pulse-time (width) modulated signals, as shown in Figure 3. In the circuit of Figure 2, $R_1$ and $R_2$ characterise the small resistance of the inductors $L_1$ and $L_2$ respectively. $C_2$ is essentially a DC-blocking capacitor, but may also affect band pass characteristics of the device.

Depending on any particular design of the RF switch, the power $P_i$ of the input signal used to control the switch S can be much less than the output RF power $P_L$ at the load resistance $R_L$, and therefore the power gain of the device can be quite high, depending on the AC supplied voltage source $V_s$. Thus, the device has both modulation and power amplification functions.

Furthermore, as we may notice, the Ohmic power loss of the device can be very low due to the use of essentially reactive components with very small resistance and switching-mode operation, especially when these inductors are made from superconductors at RF frequencies. Thus, the device can be highly efficient.

Illustratively, shown in Figures 3, 5, and 6 are some numerical results based on PSPICE simulation for the device with some specified values of relevant circuit components, which are respectively as follows: $L_1$=50nH, $L_2$=100pH, $C_1$=10pF, $C_2$=10nF, $C_s$=0.1pF, $R_1$= 0.1Ω, $R_2$=0.1Ω and $R_L$=10Ω. For the switch S, the on-state resistance is $R_{on}$=0.1Ω, and the offstate resistance is $R_{off}$=100kΩ. The peak value of the AC (sinusoidal) voltage source with a frequency of 2 GHz is $V_s$ (peak)=10V. The peak value of the pulse wave form for the signal source is $V_i$(peak)=1mV, and the fundamental frequency of the pulse wave is 100 MHz(if unmodulated).

Figure 3 shows clearly that when the sinusoidal wave of source voltage $V_s$ reaches the load resistor $R_L$ through the device, 200 Fig. 2, the wave is amplitude-modulated and its envelope has the form of pulse-time (width) modulated signals according to the pulse wave form of the signal source $V_i$, which controls the switch S. Obviously, one possible application of this type of modulation is the well-known digital modulation with amplitude shift keying (ASK).

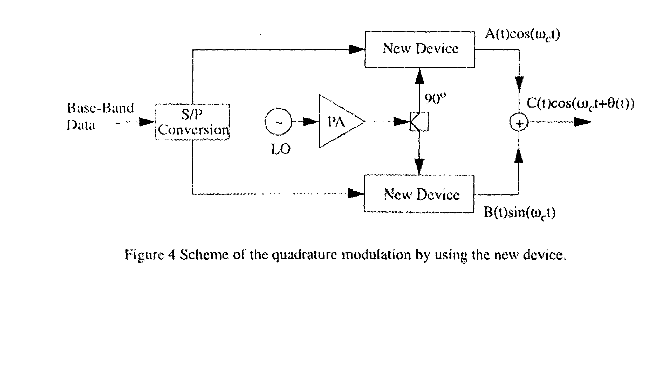

In particular, if the quadrature modulation technique is used, where one may use two separated RF carrier waves with one having 90 degree phase shift with respect to the other one, the well-known digital modulation with quadrature phase shift keying (QPSK) may also be implemented by the new device with two separated switchable bandpass filters. This is shown in the block diagram of a typical QPSK transmitter in Figure 4, now implemented using the new device of the present invention. This use of the invention can find particular application in CDMA transmission techniques where QPSK modulation is used.

The base-band data is input to a serial to parallel (S/P) converter. The bit stream is split into an in-phase and a quadrature stream, each having half the bit-rate of the base-band data signal. These two signal are now separately modulated, each by a separate implementation of the new device, each device being in quadrature. The two modulated signals, A(t) cos ($\omega_c$t) and B (t) sin ($\omega_c$t), each of which can be considered to be a ASK(amplitude shift keying) signal, are summed to produce the QPSK signal, C (t) cos ($\omega_c$t+θ(t)).

Figure 3 further shows that the phase of the current I through the load resistor $R_L$ is in-phase with the voltage V and shows that nearly all of the RF power from the AC voltage source $V_s$ can be effectively delivered to the load $R_L$ through the new device.

The PSPICE simulation result also shows that no sharp high switching (transient) voltage appears across the switch S when it switches on or off due to the presence of the capacitor $C_s$. The peak voltage across the capacitor $C_s$ is found to be nearly the same as the peak voltage value of the AC source voltage, which is 10 V in the example.

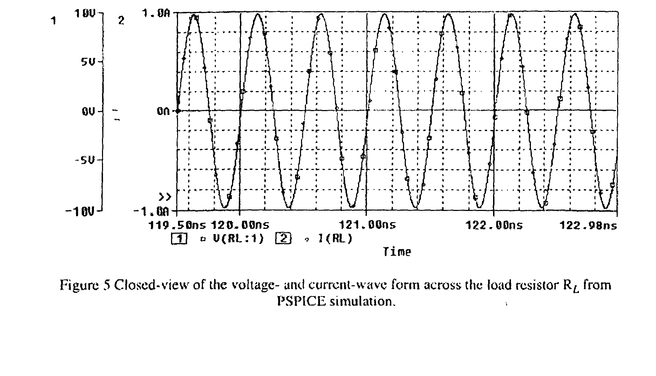

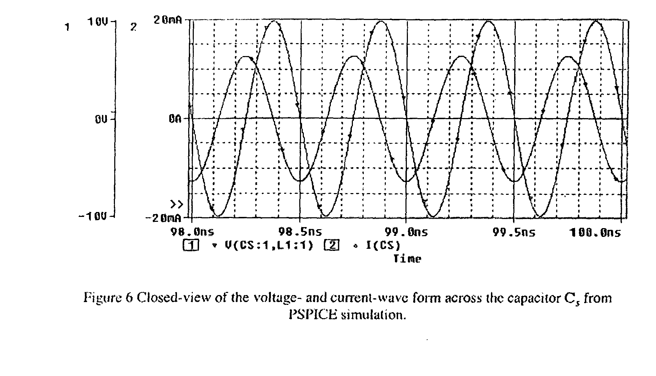

As is shown in Figure 5, the current across the capacitor $C_s$ is also not high. Furthermore, it is shown in Figure 6 that the current across the capacitor $C_s$ is 90 degrees out of phase with the voltage across the capacitor $C_s$, which implies the zero mean power consumed by $C_s$, as we may expect. The results of the PSPICE simulation have thus shown illustratively the desired functionality for the proposed device.

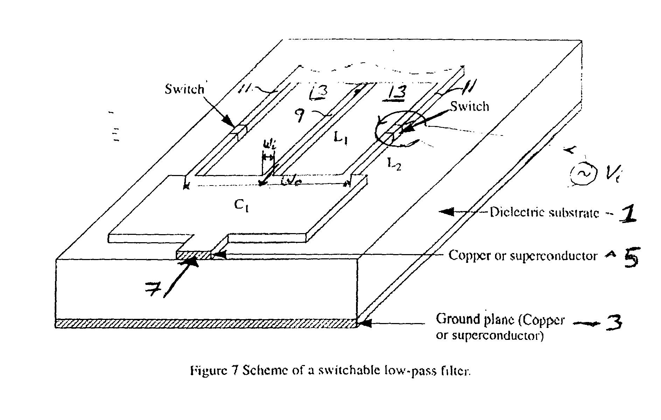

In the preferred embodiment, the switchable low-pass filter in the device will be realised by using e. g. a switchable microwave device formed by using a thin-film technology. Shown in Figure 7 is a diagram of a switchable low-pass filter. A stripline filter can be made with conductors consisting of thin sheets of various shape. Narrow sections, e.g. $L_1$ and $L_2$, can be represented in an equivalent circuit as idealised inductances, while the broad sections, e.g. $C_1$, can be represented as lumped capacitors. Thus, it can be seen that the device in Figure 7 can be used as the switchable low-pass filter part of the circuit in Figure 2.

For high frequencies such as microwave frequencies the impedance of this circuit mainly depends on the inductive and capacitive characteristics of the line, i.e.

$$Z_0 \approx \sqrt{\frac{L}{C}}$$

Thus, by controlling the inductance and/or capacitance of a stripline, the characteristic impedance $Z_0$ can be changed, resulting in a variation of voltage-current characteristic. In the particular structure of a microstrip device comprising windows relatively large changes of the characteristic impedance can be obtained by a suitable design.

In the device illustrated in Fig. 7 a dielectric substrate 1 is used having an electrically conducting ground layer 3, such as a metal layer of e.g. Cu, Ag or Au, on its bottom surface. The ground layer covers substantially all of the bottom surface as a continuous layer. On the top surface there is a patterned electrically conducting layer 5. The patterned electrically conductive layer can be either a superconductor or made of a normal electrically conductive material, e.g. copper.

The patterned layer 5 forms a transmission or propagation path intended for microwaves travelling e. g. in the direction of the arrows 7. The patterned layer 5 has a central stem path 9 having a uniform width $W_i$. Furthermore, it has lateral strips 11, both having uniform widths and extending in parallel to the central stem 9, one lateral strip 11 being located on one side of the central stem path 9 and the other lateral strip 11 being located on the opposite side of the central stem 9.

The lateral strips 11 are separated from the central stem by windows 13 in the patterned layer. They are also stripshaped and have a uniform width. The distance from an outer edge of a lateral strip 11 to the outer edge of the opposite lateral strip 11 is $W_0$. This is also the effective width of the waveguide when the lateral strips are operative to guide an electromagnetic wave.

The windows 13 have at their end a transverse portion $C_1$ extending from the central stem path 9 and the lateral strips 11. It functions here as a capacitance, analogous to the capacitor $C_1$ in Figure 2. The lateral strips 11 have, located centrally along their length, a Switch. The Switches are configured to form Josephson junctions or superconducting weak links, or possible a photo-conducting material.

In the preferred case of using a Josephson junction, a localised magnetic field can be generated at the Switch by conducting an electric current near the regions to form a superconducting current loop. The current can be generated by a voltage supply $V_i$. This voltage supply $V_i$ corresponds to the control signal $V_i$ in Figure 2. The switch S here corresponds to the switch S in Figure 2. The Josephson junctions or superconducting weak links in the Switches are controlled to take a normal or a superconducting state by this current and thereby by the supervising or control circuit signal $V_i$.

An electromagnetic wave or microwave may propagate along the transmission line structure as shown in Fig. 7. When the Switches act as electrical interrupts, the AC current in the structure due to the microwave will be confined in the central strip 9 of width $W_i$. This will correspond to the AC current from the carrier signal in Figure 2. When the special regions act as electrical connections, most of the AC current derived from the microwave will instead flow in the lateral strips 11 owing to the skin effect, or the Meissner effect if a superconductor is used, the outer edges of the lateral strips having a distance of $W_0$.

The inductance per unit length of a microstrip line is mainly determined by the total width W of the line, e.g. being approximately inversely proportional to the width W, i.e. approximately proportional to 1/W, provided that the height of the microstrip line 5 to its ground plane 3 is fixed. Thus, by changing the states of the Switches to make the lateral strips 11 continuous or interrupted, the inductance L of the microstrip line will also be changed.

Besides, the capacitance C per unit length of the transmission line will be changed, the capacitance being approximately proportional to the width W of the transmission line, provided that the height of the transmission line 5 to its ground plane 3 is fixed for a given dielectric material of the substrate 1. Thus, the characteristic impedance of the transmission line can be changed by changing the effective width W of the line such as by producing electrical interrupts in the Switches as described above.

This structure can be used to modulate the microwave, i.e. the carrier signal in Figure 2, by varying the characteristic impedance which in turn is given the active width of the structure as controlled by a supervising or signal controlling circuit. Furthermore, the power of the control signals required to change the state of, e. g. Josephson junctions or superconducting weak links in the Switches can be much smaller than the electric power of a microwave signal propagating along the structure. Therefore the structure will have an amplifying function similar to that of a transistor.

It can be seen that if the Switches are in the on-state, the inductance part of the device is mainly characterised by the inductance $L_2$, while if the switches are in the off-state, the inductance part of the device is mainly determined by the inductance $L_1$, due to different current flow paths, which are corresponding to the cases of the equivalent circuit diagram shown in Figure 2. We may notice from Figure 7 that a multisectional low-pass filter structure can also be realised if needed, depending on device specifications.

It can also be seen from the device structure shown in Figure 7 that since the RF (or microwave) power passes through the dielectric substrate 1 of the device, which can sustain much higher breakdown voltages than conventional RF power transistors, and the RF current in the device has always nearly resistance-free paths (particularly if superconductors are used) through the device, we may expect that the proposed device may be used for constructing radio transmitters with high-power handling capability and with high efficiency.

The embodiments described above serve merely as illustration and not as limitation. It will be apparent to one of ordinary skill in the art that departures may be made from the embodiments described above without departing form the spirit and scope of the invention. The invention should not be regarded as being limited to the examples described, but should be regarded instead as being equal in scope to the following claims.

**Claims**

1. A device for the amplifying and modulating a radio frequency ("RF") signal consisting of an AC voltage source $V_s$ of constant amplitude and phase, **characterised by**

   a switchable bandpass filter for filtering said signal $V_s$,

   a control signal $V_i$ for controlling said filter,

   modulating said signal $V_s$ by switching said filter under control of said control signal $V_i$,

   amplifying occurring where said control signal has lower power than said signal $V_s$.

2. The device of Claim 1 further **characterised** wherein
   said switch is one of the following: a Josephson junction, a semiconductor transistor, a photoconductor or a microelectromechanical switch.

3. The device of Claim 1 further **characterised** wherein the filter is a lowpass filter.

4. The device of Claim 1 further **characterised** wherein
   the filter comprises a planar transmission line for the carrier signal $V_s$, said planar transmission line having a central microstrip line and at least one lateral microstrip made of an electrically conducting material, the at least one lateral strip being separated from the central microstrip line by windows closed in the longitudinal direction of the central microstrip line by a bridge acting as a capacitance electrically connecting the central microstrip line and the at least one lateral strip, each lateral strip having a region forming a switch located in the middle along its length, the switch being capable of being switched between an electrically conducting state and an electrically non-conducting or high resistance state.

5. The device of Claim 4 further **characterised** wherein
   the electrically conducting material is a superconducting material and at least one switch comprises a Josephson junction or a superconducting weak link.

6. The device of Claim 4 further **characterised** wherein
   at least one switch comprise a photoconductive material.

7. The device of Claim 5 further **characterised** wherein

the switches are controlled by the control signal $V_i$.

*150*

Base-Band signal ⟶ | New Device | ⟶ ○ ○ ⋯ Ⓨ   (a)

*100a*

LO (∼) ⟶ [PA⟩ ⟶ Carrier

*130a*   *110a*   *120a*

Fig. 1A

Base-Band signal ⟶ | Modulator | ⟶ [PA⟩ ⟶ ○ ○ Ⓨ   (b)

*110b*

*120b* ⟶ Carrier   Power Amplifier

*100b*   LO (∼) *130b*

Fig. 1B

Figure 2 Schematic circuit diagram of the device.

Figure 3 Voltage wave form at the load resistor $R_L$ from PSPICE simulation.

Figure 4 Scheme of the quadrature modulation by using the new device.

Figure 5 Closed-view of the voltage- and current-wave form across the load resistor $R_L$ from PSPICE simulation.

Figure 6 Closed-view of the voltage- and current-wave form across the capacitor $C_s$ from PSPICE simulation.

Figure 7 Scheme of a switchable low-pass filter.

**European Patent Office**

## EUROPEAN SEARCH REPORT

**Application Number**

EP 00 85 0083

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 380 397 A (CENTRE NATIONAL D`ETUDES SPATIALES) 1 August 1990 (1990-08-01) * column 5, line 2 - column 8, line 7; figures 1,3 * | 1-7 | H03C7/02 |
| X | US 4 353 038 A (R. ROSE) 5 October 1982 (1982-10-05) * column 3, line 8 - column 5, line 9; figure 3 * | 1-7 | |
| X | US 4 954 791 A (M. KOENIG) 4 September 1990 (1990-09-04) * column 2, line 6 - column 3, line 40; figure 1 * * column 1, line 27 - line 52 * | 1,2 | |
| A | US 4 623 856 A (BICKLEY) 18 November 1986 (1986-11-18) * column 2, line 55 - column 3, line 22; figure 3 * * column 2, line 5 - column 3, line 40; figure 1 * * column 1, line 5 - column 2, line 40 * | 1-7 | |
| A | DE 39 33 055 A (TELEFUNKEN SYSTEMTECHNIK) 11 April 1991 (1991-04-11) * column 2, line 66 - column 4, line 7; figure 3 * | 1-7 | TECHNICAL FIELDS SEARCHED (Int.Cl.7) H03C H03B H01P |

The present search report has been drawn up for all claims

| Place of search | Date of completion of the search | Examiner |
|---|---|---|
| THE HAGUE | 31 October 2000 | Butler, N |

**ANNEX TO THE EUROPEAN SEARCH REPORT
ON EUROPEAN PATENT APPLICATION NO.**

EP 00 85 0083

This annex lists the patent family members relating to the patent documents cited in the above-mentioned European search report.
The members are as contained in the European Patent Office EDP file on
The European Patent Office is in no way liable for these particulars which are merely given for the purpose of information.

31-10-2000

| Patent document cited in search report | | Publication date | Patent family member(s) | | Publication date |
|---|---|---|---|---|---|
| EP 380397 | A | 01-08-1990 | FR | 2642238 A | 27-07-1990 |
| | | | AT | 98405 T | 15-12-1993 |
| | | | DE | 69004985 D | 20-01-1994 |
| | | | DE | 69004985 T | 24-03-1994 |
| US 4353038 | A | 05-10-1982 | AU | 8331182 A | 19-10-1982 |
| | | | CA | 1175509 A | 02-10-1984 |
| | | | EP | 0075583 A | 06-04-1983 |
| | | | WO | 8203509 A | 14-10-1982 |
| US 4954791 | A | 04-09-1990 | DE | 4024800 A | 11-04-1991 |
| | | | GB | 2237698 A,B | 08-05-1991 |
| US 4623856 | A | 18-11-1986 | NONE | | |
| DE 3933055 | A | 11-04-1991 | NONE | | |

EPO FORM P0459

For more details about this annex : see Official Journal of the European Patent Office, No. 12/82